# EUROPEAN PATENT APPLICATION

(11) **EP 4 503 064 A1**
(43) Date of publication of application: **05.02.2025**
(21) Application number: 23779302.1
(22) Date of filing: 07.03.2023
(51) Int. Cl.: H01B 12/10

(54) **COMPOUND SUPERCONDUCTING PRECURSOR WIRE, COMPOUND SUPERCONDUCTING PRECURSOR STRAND, AND COMPOUND SUPERCONDUCTING STRAND**

(30) Priority: 31.03.2022 JP 2022061124
(71) Applicant: FURUKAWA ELECTRIC CO., LTD., Tokyo 100-8322 (JP); TOHOKU UNIVERSITY, Sendai-shi Miyagi 980-8577 (JP); TOKAI UNIVERSITY EDUCATIONAL SYSTEM, Tokyo 151-0063 (JP)
(72) Inventor: SUGIMOTO Masahiro, Tokyo 100-8322 (JP); HIROSE Kiyoshige, Tokyo 100-8322 (JP); FUKUSHIMA Hiroyuki, Tokyo 100-8322 (JP); TANIGUCHI Ryo, Tokyo 100-8322 (JP); AWAJI Satoshi, Sendai-shi, Miyagi 980-8577 (JP); OGURO Hidetoshi, Hiratsuka-shi, Kanagawa 259-1292 (JP)
(74) Representative: Winter, Brandl - Partnerschaft mbB
(86) International application number: PCT/JP2023/008522
(87) International publication number: WO 2023/189275

(57) **Abstract**

This compound superconducting precursor wire includes: a compound superconducting precursor portion including a plurality of compound superconducting precursor filaments, and a first matrix precursor having the plurality of compound superconducting precursor filaments embedded therein and including a first stabilizing material; a reinforcing material portion disposed on an outer peripheral side of the compound superconducting precursor portion; and a stabilizing material portion which is disposed on at least one of an inner peripheral side and an outer peripheral side of the reinforcing material portion, and consisting of a second stabilizing material, in which a Vickers hardness (HV) of the stabilizing material portion is 90 or less, and a 0.2% tensile strength of the compound superconducting precursor wire is 200 MPa or more.

## Description

### TECHNICAL FIELD

The present disclosure relates to a compound superconducting precursor wire, a compound superconducting precursor strand, and a compound superconducting strand.

### BACKGROUND ART

In a compound superconducting strand which is applied to a large-scale superconducting magnet for generating a strong magnetic field and having increased current by twisting together a plurality of compound superconducting wires of Nb₃Sn or the like, in order to suppress a performance decline caused by movement of the wires due to electromagnetic stress applied during operation of the magnet, and to increase conductor current density, a structure has been established which shortens the twisting pitch and decreases a void ratio of the strands (proportion of a void portion in the strand).

However, when the twisting pitch is shortened in the step (twisting step) of twisting together the wires before the compound superconductivity generating heat treatment (hereinafter, also referred to as compound superconducting precursor wire), and the void ratio of the strand is decreased in the subsequent compression step, there has been a problem in that the frequency of locally applying a large processing stress to the compound superconducting precursor wire increases, and abnormal deformation or breakage occurs in the compound superconducting precursor wire, whereby the manufacturing yield significantly decreases. Further, in the Nb₃Sn superconducting magnet in which the strand obtained by twisting the Nb₃Sn precursor wires in the abnormal state is subjected to the superconductivity generating heat treatment, there have been problems in that a large strain is applied to the Nb₃Sn filaments in the Nb₃Sn wire due to the electromagnetic stress generated at the time of excitation, and not only is deteriorated the superconducting property, but also in extreme cases, cracks occur in the Nb₃Sn filaments and the superconducting state cannot be maintained.

On the other hand, the Nb₃Sn superconducting magnet obtained by conducting the superconductivity generating heat treatment for a strand made by twisting together a high-strength type Nb₃Sn precursor wire in which a high-strength material is composited inside the Nb₃Sn precursor wire and a plurality of wires exhibits excellent superconducting characteristics, even under a large electromagnetic stress generated at the time of excitation. However, in the Nb₃Sn precursor wire composited with the high-strength material, since the spring-back of the wire itself will be large depending on its configuration, when it is necessary to shorten the twisting pitch or to decrease the void ratio of the strand, it is difficult to control the size to the required dimensions with a predetermined strand structure, and thus there has been a problem in the strand manufacturability. Many technical developments have been made to address the above such problems thus far.

For example, Patent Document 1 describes a Nb₃Sn superconducting wire composited with a CuNb reinforcing material in which a large number of Nb filaments are embedded in a Cu base material. In addition, Patent Document 2 describes a CuNb-reinforcement type compound superconducting strand in which the cross-sectional structure of a compound superconducting wire is defined and higher strength is given priority. However, Patent Documents 1 and 2 focus on improvements in superconducting performance under stress, and do not take into consideration improvements in strand processability, and thus cannot be applied as is to the manufacture of large-capacity conductors.

In addition, Patent Document 3 discloses a technique for Nb₃Sn superconducting precursor wires according to the PIT method, whereby stabilization is ensured due to high-conductivity Cu, and particularly favorable current stability is obtained, by stranding wires into a specific Sn diffusion barrier structure. However, Patent Document 3 does not intend to improve the manufacturability of strands or to strengthen the strands themselves, and thus cannot be applied to a compound superconducting stranded conductor to which a large electromagnetic stress is applied during operation.

In addition, Patent Document 4 discloses a technique for refining an alloy wire by annealing to improve the processability of a strand. Furthermore, Patent Document 5 discloses a technique for improving the shape of a strand having specified dimensions by annealing, followed by molding the strand. Patent Document 6 discloses a technique for improving the shape of a strand by molding an annealed wire or primary stranded wire, and then re-annealing it. However, Patent Documents 4 to 6 are all intended to improve strand processability, but cannot be applied as is to a compound superconducting stranded conductor to which a large electromagnetic stress is applied during operation.

In addition, Non-Patent Documents 1 and 2 show the performance of the Nb rod method Cu-Nb-reinforced Nb₃Sn wire, and do not show technology for improving the manufacturability of a compound superconducting precursor strand used for a large-capacity conductor.

In addition, in Non-Patent Documents 3 and 4, techniques are introduced for suppressing a performance decline due to a strong electromagnetic stress during operation, by shortening the twisting pitch and decreasing the void ratio of the strand, in order to improve the current-carrying characteristics of a conductor for ITER-CS (conductor for center solenoids for International Nuclear Fusion Experimental Reactor); however, a technique has not been shown for improving the manufacturability of strands.

In addition, Non-Patent Document 5 is a report on the development results of a multi-twist stranded wire in which many copper wires are co-twisted, the twisting pitch is lengthened, and the void ratio of the strand is reduced to make into a flat shape, and does not show technology for improving the manufacturability of strands.

Patent Documents 1 to 6 and Non-Patent Documents 1 to 5 describe the results of academic studies to optimize compound superconducting wire material and stranded conductor designs. As a problem to be solved in order to rationally design and manufacture a stranded conductor for an actual coil, it is necessary to achieve both an improvement in superconducting property under electromagnetic stress during operation and an improvement in manufacturability of the stranded conductor.

### Citation List

### Patent Document

Patent Document 1: Japanese Patent No. 6155253
Patent Document 2: PCT International Publication No. WO2020/066908
Patent Document 3: Japanese Patent No. 6425673
Patent Document 4: Japanese Patent No. 6201815
Patent Document 5: Japanese Patent No. 3148212
Patent Document 6: Japanese Patent No. 2930994

### Non-Patent Document

Non-Patent Document 1: M. Sugimoto, et al., "Development of Nb-rod-method Cu-Nb reinforced Nb3Sn Rutherford cables for react-and-wind processed wide-bore high magnetic field coils", IEEE Trans. Appl. Supercond., Vol. 25, No.3(2015)6000605
Non-Patent Document 2: M. Sugimoto, et al., "Evaluation of Various Nb-Rod-Method Cu-Nb/Nb3Sn Wires Designed for Practical React-and-Wind Coils", IEEE Trans. Appl. Supercond., Vol. 30, No. 4(2020)6000905
Non-Patent Document 3: IEEE Trans. on Appl. Super.,24 3(2014) 4802404, Y. Takahashi
Non-Patent Document 4: IEEE Trans. on Appl. Super., 24 3(2014) 4200705, Y. Nabara
Non-Patent Document 5: IEEE Trans. on Appl. Super., 27 4(2017) 4800206, L. Muzzi

### DISCLOSURE OF THE INVENTION

### Problems to be Solved by the Invention

A large-scale superconducting conductor applied to the manufacture of large-scale superconducting magnets using a compound-based superconducting wire material such as Nb₃Sn has a stranded structure. This stranded structure includes a round twisted structure and a flat structure; however, in order to improve the current density per cross section of the strand and to prevent the twisting from being broken, molding processing (compression processing) is performed. In such a stranded structure, a multi-twisted structure (high-order twisted structure) in which a strand is manufactured by twisting a plurality of times instead of being manufactured by a single twist (strand in which wires are twisted only once) may be used.

As described above, in the related art, in the Nb₃Sn superconducting strand applied to the large-scale superconducting magnet, in order to increase the current density and to suppress the movement of the superconducting wire due to the electromagnetic stress at the time of energization, a configuration in which the twisting pitch is reduced or a configuration in which the void ratio of the strand is decreased is adopted. Therefore, in the strand manufacturing process using the wires before the Nb₃Sn generation heat treatment (Nb₃Sn precursor wires), the wires are broken in the strand processing step for shortening the twisting pitch, or abnormal deformation of the structural material inside the wires occurs in the compression step for reducing the void ratio of the strands, and in extreme cases, the strands are broken. In either of a Nb₃Sn superconducting magnet subjected to the Nb₃Sn generation heat treatment after performing coil winding (by the wind-and-react method) and a Nb₃Sn superconducting magnet on which coil winding is performed after subjecting to the Nb₃Sn generation heat treatment (by the react-and-wind method) using the Nb₃Sn precursor stranded conductor in such a defective state, there is a problem in that a large strain is applied to the Nb₃Sn filament in the wire constituting the Nb₃Sn superconducting strand by the electromagnetic stress generated during the operation of the magnet, and the superconducting property is deteriorated, and in an extreme case, cracks occur in the Nb₃Sn filament, and thus the superconducting state cannot be maintained.

An object of the present disclosure is to provide a compound superconducting precursor wire, a compound superconducting precursor strand, and a compound superconducting strand, which are superior in strand manufacturing property and superconducting property relative to those of the related art.

### Means for Solving the Problems

[1] A compound superconducting precursor wire includes: a compound superconducting precursor portion including a plurality of compound superconducting precursor filaments, and a first matrix precursor having the plurality of compound superconducting precursor filaments embedded therein and including a first stabilizing material; a reinforcing material portion disposed on an outer peripheral side of the compound superconducting precursor portion; and a stabilizing material portion which is disposed on at least one of an inner peripheral side and an outer peripheral side of the reinforcing material portion, and consisting of a second stabilizing material, in which a Vickers hardness (HV) of the stabilizing material portion is 90 or less, and a 0.2% tensile strength of the compound superconducting precursor wire is 200 MPa or more.
[2] In the compound superconducting precursor wire as described in the above [1], the reinforcing material portion consists of one metal selected from the group consisting of Nb, Ta, V, W, Mo, Fe, Ti and Hf, or an alloy or composite material composed of two or more of the metals.
[3] In the compound superconducting precursor wire as described in the above [1], the reinforcing material portion is configured by a plurality of reinforcing filaments, and a third matrix having the plurality of reinforcing filaments embedded therein and including a third stabilizing material.
[4] In the compound superconducting precursor wire as described in the above [3], the reinforcing filament consists of one metal selected from the group consisting of Nb, Ta, V, W, Mo, Fe, Ti, and Hf, or an alloy composed of two or more of the metals, and the third stabilizing material is copper or a copper alloy.
[5] In the compound superconducting precursor wire as described in any one of the above [1] to [4], the compound superconducting precursor filament is an Nb₃Sn precursor, and the compound superconducting precursor wire further comprises a Sn diffusion prevention portion consisting of Nb or Ta, or an alloy or composite material thereof, between the compound superconducting precursor portion and the reinforcing material portion.
[6] In the compound superconducting precursor wire as described in any one of the above [1] to [5], the first stabilizing material is copper or a copper alloy.
[7] In the compound superconducting precursor wire as described in any one of the above [1] to [6], the second stabilizing material is copper or a copper alloy.
[8] In the compound superconducting precursor wire as described in any one of the above [1] to [7], a space factor of the reinforcing material portion is 5.0% or more and 40.0% or less, and smaller than a space factor of the compound superconducting precursor portion, and a space factor of the stabilizing material portion disposed on an outer peripheral side of the reinforcing material portion is 15.0% or more.
[9] A compound superconducting precursor strand includes, as a constituent element, a secondary stranded wire provided by twisting together a plurality of primary stranded wires provided by twisting together a plurality of the compound superconducting precursor wires as described in any one of the above [1] to [8].
[10] A compound superconducting precursor strand includes, as a constituent element, a secondary stranded wire provided by twisting together a plurality of primary stranded wires provided by twisting together one or a plurality of the compound superconducting precursor wires as described in any one of the above [1] to [8], and one or a plurality of copper wires or copper alloy wires.
[11] In the compound superconducting precursor strand as described in the above [10], a Vickers hardness (HV) of the copper wire or the copper alloy wire is 90 or less.
[12] In the compound superconducting precursor strand as described in any one of the above [9] to [11], a maximum oblateness of the compound superconducting precursor portion in one or a plurality of transverse cross sections of the compound superconducting precursor wires constituting the compound superconducting precursor strand is more than 0 and 0.2 or less.
[13] A compound superconducting strand obtained by heating the compound superconducting precursor strand as described in any one of the above [9] to [12].

### Effects of the Invention

According to the present disclosure, it is possible to provide a compound superconducting precursor wire, a compound superconducting precursor strand, and a compound superconducting strand, which are superior in strand manufacturing property and superconducting property relative to those of the related art.

### BRIEF DESCRIPTION OF THE DRAWINGS

FIG. 1 is a transverse cross-sectional view showing an example of a compound superconducting precursor wire according to an embodiment.
FIG. 2 is a transverse cross-sectional view showing another example of the compound superconducting precursor wire according to the embodiment.
FIG. 3 is a transverse cross-sectional view showing an example of a compound superconducting precursor strand according to the embodiment.
FIG. 4 is a transverse cross-sectional view showing an example of a compound superconducting precursor wire constituting the compound superconducting precursor strand according to the embodiment.
FIG. 5 is a transverse cross-sectional view showing an example of a compound superconducting wire constituting the compound superconducting strand according to the embodiment.
FIG. 6 is a transverse cross-sectional view showing another example of a compound superconducting wire constituting the compound superconducting strand according to the embodiment.
FIG. 7 is a transverse cross-sectional view showing another example of a compound superconducting wire constituting the compound superconducting strand according to the embodiment.

### PREFERRED MODE FOR CARRYING OUT THE INVENTION

Hereinafter, embodiments will be described in detail.

The present inventors have conducted intensive studies on compound superconducting precursor strands such as Nb₃Sn precursor strands obtained by twisting together a plurality of compound superconducting wires, in order to obtain excellent manufacturability and to obtain excellent superconducting property when incorporating into a superconducting magnet as a compound superconducting strand, and as a result, by the properties of a stabilizing material portion and the compound superconducting precursor wire constituting the compound superconducting wire satisfying a predetermined relationship, respectively, the present inventors came to invent a compound superconducting precursor wire and a compound superconducting precursor strand made using this, as well as a compound superconducting strand obtained by subjecting the strand to a compound superconductivity generating heat treatment for generating a compound superconducting phase after the stranding, solving the problem of the prior art.

First, the compound superconducting precursor wire according to the embodiment will be described.

A compound superconducting precursor wire according to an embodiment includes: a compound superconducting precursor portion including a plurality of compound superconducting precursor filaments, and a first matrix precursor having the plurality of compound superconducting precursor filaments embedded therein and containing a first stabilizing material; a reinforcing material portion disposed on an outer peripheral side of the compound superconducting precursor portion; and a stabilizing material portion which is disposed on at least one of an inner peripheral side and an outer peripheral side of the reinforcing material portion, and consisting of a second stabilizing material, in which a Vickers hardness (HV) of the stabilizing material portion is 90 or less, and a 0.2% tensile strength of the compound superconducting precursor wire is 200 MPa or more.

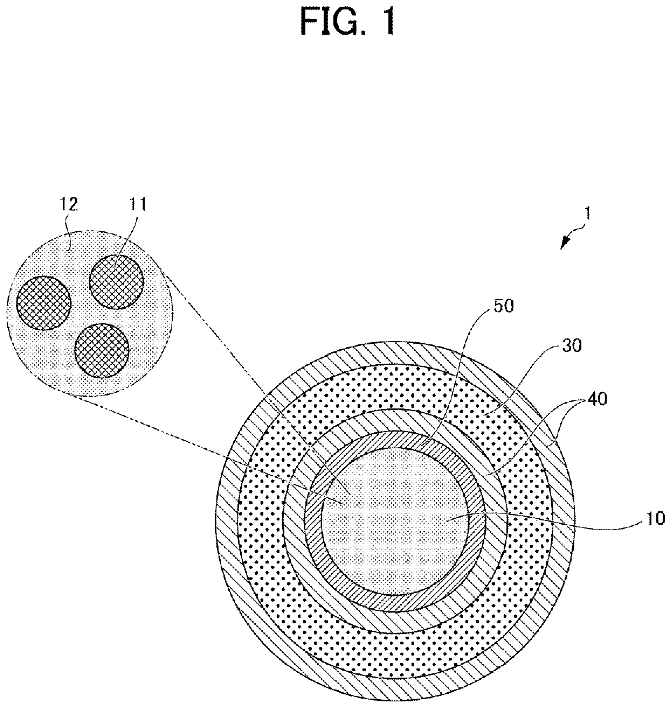

FIG. 1 is a transverse cross-sectional view showing an example of a compound superconducting precursor wire according to the embodiment. As shown in FIG. 1, the compound superconducting precursor wire 1 includes a compound superconducting precursor portion 10, a reinforcing material portion 30, and a stabilizing material portion 40.

The compound superconducting precursor portion 10 constituting the compound superconducting precursor wire 1 is constituted by a plurality of compound superconducting precursor filaments 11 and a first matrix precursor 12. The compound superconducting precursor portion 10 is linear and extends along the axial direction of the compound superconducting precursor wire 1 (wire axial direction). The first matrix precursor 12 embeds the plurality of compound superconducting precursor filaments 11, and includes a first stabilizing material.

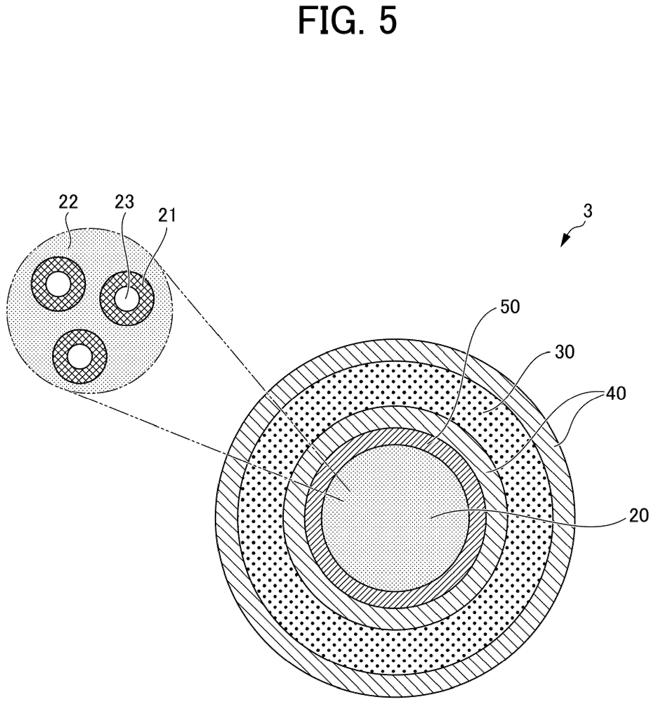

The compound superconducting precursor filament 11 becomes a compound superconducting filament 21 including the compound superconducting phase shown in FIGS. 5 to 7 described later, by conducting a compound superconductivity generating heat treatment for generating a compound superconducting phase to be described later. Since the compound superconducting phase constituting the compound superconducting wire 3 described later is preferably a metal compound superconducting phase formed of Nb₃Sn, the compound superconducting precursor filament 11 is preferably an Nb₃Sn precursor, and more preferably Nb. The material constituting the compound superconducting precursor filament 11 is appropriately selected according to the type of compound superconducting phase.

The first matrix precursor 12 containing the first stabilizing material becomes a first matrix 22 containing the first stabilizing material shown in FIGS. 5 to 7, by subjecting to a compound superconducting generating heat treatment. The first matrix 22 can exhibit effects of suppressing damage to the compound superconducting filament 21, magnetic stabilization, and thermal stabilization in the compound superconducting wire 3. When the first stabilizing material constituting the first matrix precursor 12 is copper or a copper alloy, these effects are further improved.

In addition, since the compound superconducting phase is preferably a metal compound superconducting phase formed of Nb₃Sn, the first stabilizing material is preferably formed of a Cu-Sn alloy. The material constituting the first stabilizing material is appropriately selected according to the type of the compound superconducting phase constituting the compound superconducting wire 3.

When the first stabilizing material of the first matrix precursor 12 is a Cu-Sn alloy, the first stabilizing material can contain Sn at a maximum of 15.8% by mass (solid solubility limit). In addition, the first stabilizing material of the first matrix precursor 12 may contain a small amount of another element other than Cu and Sn and, for example, Ti or the like is preferably contained in a range of 0.20% by mass or more and 0.35% by mass or less.

FIG. 1 and FIGS. 2, 5 and 6 described later show an example in which a compound superconducting phase of Nb₃Sn is generated by a bronzing method; however, another method such as an internal tin method may be applied to the generation of the compound superconducting phase of Nb₃Sn. In addition, although an example in which the compound superconducting phase is Nb₃Sn is illustrated here, the compound superconducting phase may be a compound superconductor having a superconducting property with higher strain sensitivity compared to an alloy-based superconductor such as NbTi.

The reinforcing material portion 30 constituting the compound superconducting precursor wire 1 has a cylindrical shape, and is disposed on the outer peripheral side of the compound superconducting precursor portion 10. The reinforcing material portion 30 preferably consists of one metal selected from the group consisting of Nb, Ta, V, W, Mo, Fe, Ti and Hf, or an alloy or composite material composed of two or more of these metals. It should be noted that the reinforcing material portion 30 may contain inevitable impurities. The reinforcing material portion 30 can exert an effect of providing a high-strength function resistant to tensile strain and bending strain.

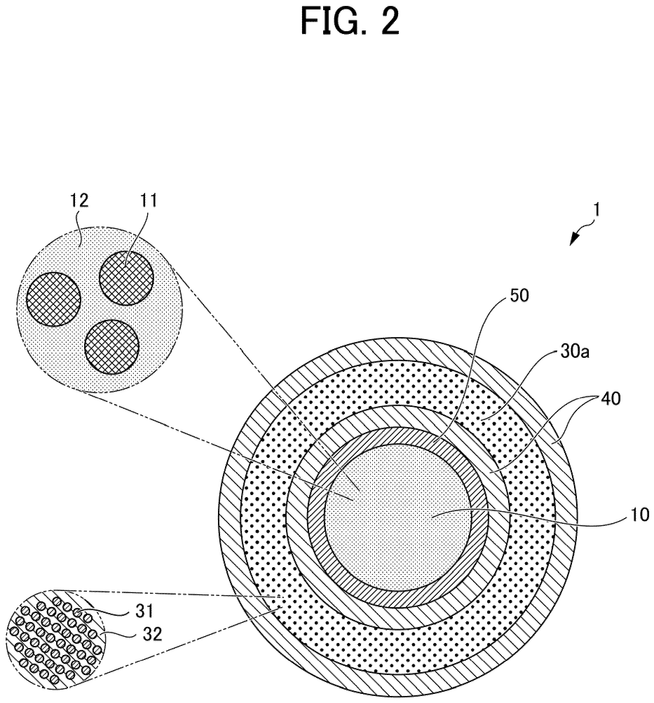

In addition, as shown in FIG. 2, the reinforcing material portion 30a may be constituted by a plurality of reinforcing filaments 31 and a third matrix 32. The third matrix 32 embeds the plurality of reinforcing filaments 31, and includes a third stabilizing material. The reinforcing material portion 30a including the plurality of reinforcing filaments 31 and the third matrix 32 can exert an effect of appropriately providing not only the high-strength function but also a stabilizing function, compared with the reinforcing material portion 30.

The reinforcing filament 31 constituting the reinforcing material portion 30a preferably consists of one metal selected from the group consisting of Nb, Ta, V, W, Mo, Fe, Ti and Hf, or an alloy composed of two or more of these metals. It should be noted that the reinforcing filament 31 may contain inevitable impurities.

For example, when the reinforcing filament 31 mainly contains Nb, for example, 150 ppm or less of O, 15 ppm or less of H, 100 ppm or less of C, 100 ppm or less of N, 50 ppm or less of Fe, 50 ppm or less of Ni, 20 ppm or less of Ti, 50 ppm or less of Si, 300 ppm or less of W, and 1000 ppm or less of Ta may be contained as inevitable impurities. In addition, when the reinforcing filament 31 mainly contains Ta, then O, H, C, N, Fe, Ni, Ti, Si, W, Nb, and Mo may be contained as inevitable impurities.

Since these metals or alloys constituting the reinforcing filament 31 are less likely to dissolve in Cu during the compound superconductivity generating heat treatment, a compound with Cu is less likely to be formed, which effectively contributes to an improvement in the bending strain characteristics. In consideration of the influence on the compound superconducting wire 3, among them, the reinforcing filament 31 preferably consists of one metal selected from the group consisting of Nb, Ta, V, W, Mo and Hf which do not exhibit ferromagnetic properties, or an alloy composed of two or more of these metals, and from the viewpoint of processability, preferably consists of one metal selected from the group consisting of Nb, Ta and V, or an alloy composed of two or more of these metals.

In addition, the alloy composed of two or more metals selected from the above-described group of elements constituting the reinforcing filament 31 is preferably an Nb-Ta alloy, from the viewpoint of excellent composite processability with copper or a copper alloy. In addition, as the alloy composed of a metal selected from the above-described group of elements and copper, a Cu-Nb alloy or a Cu-V alloy is preferable, from the viewpoint of excellent composite processability with copper or a copper alloy.

The above-described matter of being less likely to form a solid solution in Cu refers to the proportion of the metal or alloy constituting the reinforcing filament 31 forming a solid solution in Cu being less than 1 at% in the compound superconductivity generating heat treatment (e.g., 600°C to 750°C).

As described above, in the reinforcing material portion 30a, the plurality of reinforcing filaments 31 constituted by the metal material which is less likely form a solid solution in Cu are embedded in the third matrix 32. Therefore, it is possible to suppress an intermetallic compound from being generated in the reinforcing filament 31 inside the reinforcing material portion 30a, and thus the reinforcing material portion 30a can function as a higher-strength component that is resilient to tensile strain and bending strain compared with the reinforcing material portion 30.

The third stabilizing material constituting the third matrix 32 of the reinforcing material portion 30a is preferably copper or a copper alloy. It should be noted that the third stabilizing material may contain inevitable impurities. Inevitable impurities of the third stabilizing material include O, Fe, S, and Bi. The third matrix 32 including the third stabilizing material can exert an effect of providing the reinforcing material portion 30 with a stabilizing function in addition to the reinforcing function.

The stabilizing material portion 40 constituting the compound superconducting precursor wire 1 has a tubular shape, and is disposed on at least one of the inner peripheral side and the outer peripheral side of the reinforcing material portion 30. The stabilizing material portion 40 consists of a second stabilizing material. FIGS. 1 and 2 show an example in which the stabilizing material portion 40 is disposed on both the inner peripheral side and the outer peripheral side of the reinforcing material portion 30. The stabilizing material portion 40 can exert effects of suppressing abnormal deformation during processing of the reinforcing material portion 30, and providing a stabilizing function.

The second stabilizing material constituting the stabilizing material portion 40 is preferably copper or a copper alloy, and more preferably oxygen-free copper. The second stabilizing material may contain inevitable impurities. Inevitable impurities of the second stabilizing material include O, Fe, S, and Bi.

Furthermore, as described above, the first stabilizing material constituting the compound superconducting precursor portion 10, the second stabilizing material constituting the stabilizing material portion 40, and the third stabilizing material constituting the reinforcing material portion 30a are used in the compound superconducting precursor wire 1. As defined in JIS H 7005:2005, the term "stabilizing material" as used herein refers to a normal conduction metallic material which is generally a metal material that ensures thermal contact with a refrigerant, and/or is in electrical and/or thermal contact with a superconductor so as to act as an electrical shunt circuit, the metal material being combined with the superconductor to increase the stability of the superconductor. Specifically, the normal conduction metal such as copper or aluminum has low specific resistance at extremely low temperature and good thermal conductivity; therefore, when used as a matrix of a superconducting wire, even if there is a transition from a superconducting state to a normal conduction state, the current will flow by bypassing to the normal conduction metal. In the compound superconducting wire 3 described later, heat generation is thereby suppressed, and the generated heat is rapidly propagated and diffused to be cooled. Furthermore, the normal conduction metal such as copper or aluminum, which dampen the external magnetic flux fluctuation and does not directly transmit the magnetic flux fluctuation to the superconductor, are widely used as a stabilizing material for the superconducting wire.

In addition, the Vickers hardness (HV) of the stabilizing material portion 40 is 90 or less, and the 0.2% tensile strength of the compound superconducting precursor wire 1 is 200 MPa or more. The Vickers hardness of the stabilizing material portion 40 is the Vickers hardness of the stabilizing material portion 40 in a cross section perpendicular to the axial direction of the compound superconducting precursor wire 1. In addition, the 0.2% tensile strength of the compound superconducting precursor wire 1 is the 0.2% tensile strength of the compound superconducting precursor wire 1 in the axial direction.

When the Vickers hardness (HV) of the stabilizing member portion 40 is 90 or less and the 0.2% tensile strength of the entire compound superconducting precursor wire 1 is 200 MPa or more, it is possible to suppress breakage of the compound superconducting precursor wire 1 and abnormal deformation of the compound superconducting precursor portion 10 inside the compound superconducting precursor wire 1, which have been conventionally caused, and thus the strand manufacturability can be improved. Furthermore, the compound superconducting magnet manufactured using the compound superconducting precursor strand formed by twisting together a plurality of compound superconducting precursor wires 1 is robust even under a strong electromagnetic stress generated when excited, and can maintain superior superconducting characteristics. In this way, since the compound superconducting precursor wire 1 and the compound superconducting precursor strand 2 are excellent in manufacturability, and the compound superconducting strand is robust and excellent in superconducting property, they can be used for the compound superconducting magnet with rational design.

For the above reasons, the Vickers hardness of the stabilizing material portion 40 is 90 or less, preferably 80 or less, and more preferably 70 or less. For the same reasons, the 0.2% tensile strength of the compound superconducting precursor wire 1 is 200 MPa or more, preferably 230 MPa or more, and more preferably 250 MPa or more. It should be noted that the Vickers hardness of the stabilizing material portion 40 is preferably 50 or more in order to suppress the occurrence of unacceptable abnormal deformation or harmful external damage in the stranding process or the compression process. In addition, the 0.2% tensile strength of the compound superconducting precursor wire 1 is desirably 400 MPa or less in order to maintain favorable strand workability.

In addition, when the compound superconducting precursor filament 11 of the compound superconducting precursor portion 10 is an Nb₃Sn precursor, the compound superconducting precursor wire 1 preferably further includes a Sn diffusion prevention portion 50 consisting of Nb or Ta, or an alloy or composite material of these, between the compound superconducting precursor portion 10 and the reinforcing material portion 30.

The Sn diffusion prevention portion 50 has a function of preventing Sn in the Cu-Sn alloy constituting the first matrix precursor 12 for forming the Nb₃Sn filament in the compound superconductor portion 20 from diffusing into the reinforcing material portion 30 and the stabilizing material portion 40 during the compound superconductivity generating heat treatment, suppressing a decline in the residual resistance ratio of the second stabilizing material constituting the stabilizing material portion 40 and the third stabilizing material constituting the reinforcing material portion 30, and retaining, in the Cu-Sn alloy, the Sn amount necessary to react with the Nb filaments of the compound superconducting precursor filament 11 to produce Nb₃Sn.

In addition, in the compound superconducting precursor wire 1, it is preferable that the space factor of the reinforcing material portion 30 is 5.0% or more and 40.0% or less, is smaller than the space factor of the compound superconducting precursor portion 10, and the space factor of the stabilizing material portion 40 disposed on the outer peripheral side of the reinforcing material portion 30 is preferably 15.0% or more. When the space factor of the reinforcing material portion 30 and the space factor of the stabilizing material portion 40 are respectively within the above ranges, the critical current of the compound superconducting precursor wire 1 can be further improved.

The space factor of each constituent portion is a ratio of the area of each constituent portion to a cross-sectional area perpendicular to the axial direction of the compound superconducting precursor wire 1. Specifically, the space factor of the reinforcing material portion 30 is a ratio of the area of the reinforcing material portion 30 to the transverse cross-sectional area of the compound superconducting precursor wire 1. The space factor of the compound superconducting precursor portion 10 is the ratio of the area of the compound superconducting precursor portion 10 to the transverse cross-sectional area of the compound superconducting precursor wire 1. The space factor of the stabilizing material portion 40 is a ratio of the area of the stabilizing material portion 40 to the transverse cross-sectional area of the compound superconducting precursor wire 1.

Next, the compound superconducting precursor strand of the embodiment will be described.

The compound superconducting precursor strand of the embodiment includes, as a constituent element, a secondary stranded wire provided by twisting together a plurality of primary stranded wires provided by twisting together a plurality of the compound superconducting precursor wires of the above embodiment. Further, the compound superconducting precursor strand of another embodiment has, as a constituent element, a secondary stranded wire provided by twisting together a plurality of primary stranded wires provided by twisting together one or a plurality of the compound superconducting precursor wires of the above embodiment, and one or a plurality of copper wires or copper alloy wires. In contrast to the compound superconducting precursor strand of the above embodiment having the secondary stranded wire composed only of the compound superconducting precursor wires as a constituent element, the compound superconducting precursor strand of another embodiment includes one or more copper wires or copper alloy wires in each order of stranded wire.

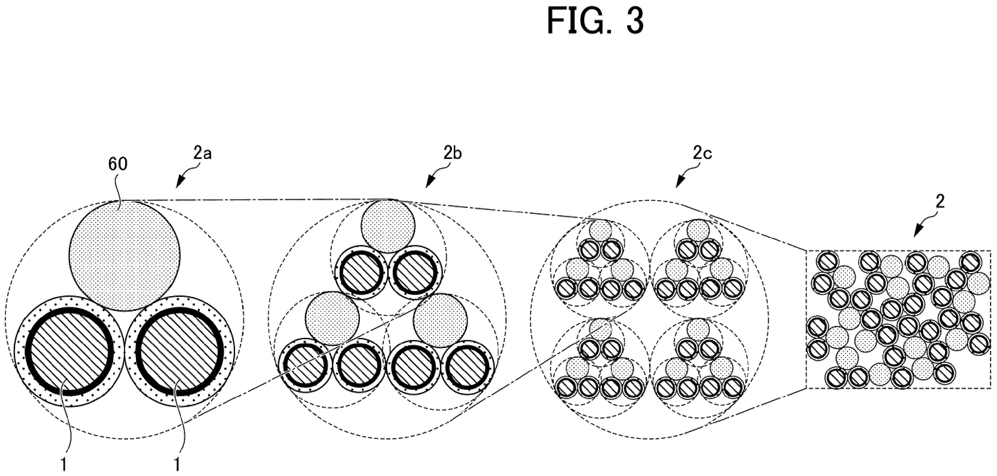

FIG. 3 is a transverse cross-sectional view showing an example of a compound superconducting precursor strand according to another embodiment. Herein, a compound superconducting precursor strand 2 is shown in which a secondary stranded wire 2b formed by twisting three primary stranded wires 2a formed by co-twisting two compound superconducting precursor wires 1 and one copper wire 60 together is used as a component, and a tertiary stranded wire 2c formed by twisting four secondary stranded wires 2b together is subjected to a rectangular molding process.

At the time of manufacturing the compound superconducting precursor strand 2, the compound superconducting precursor wire 1 is refined by conducting a heat treatment at 200°C or more and 500°C or less for several seconds or more and within several hours in a state before conducting the molding process. It is sufficient if this refinement is in a state before conducting the molding process, and thus it may be the compound superconducting precursor wire 1 before twisting, the primary stranded wire 2a, the secondary stranded wire 2b, or the tertiary stranded wire 2c. This refinement controls the Vickers hardness of the stabilizing material portion 40 and the 0.2% tensile strength of the compound superconducting precursor wire. In addition, in the case of refining a strand such as the primary stranded wire, it is preferable to perform refining for controlling the strength of the copper wire or the copper alloy wire twisted with the compound superconducting precursor wire.

In the compound superconducting precursor strand 2, the Vickers hardness (HV) of the copper wire or the copper alloy wire is preferably 90 or less, more preferably 80 or less, and still more preferably 70 or less. The Vickers hardness of the copper wire or the copper alloy wire is the Vickers hardness of the copper wire or the copper alloy wire in a cross section perpendicular to the axial direction of the copper wire or the copper alloy wire. The compound superconducting precursor strand 2 in which the Vickers hardness (HV) of the copper wire or the copper alloy wire is within the above range is suitably used in a large-scale superconducting magnet for generating a strong magnetic field mounted in a nuclear fusion reactor or the like.

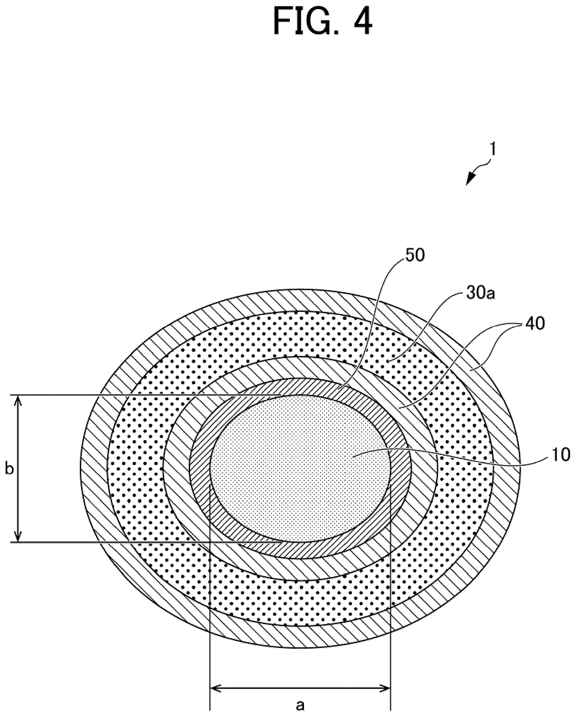

In addition, FIG. 4 is a transverse cross-sectional view showing an example of a compound superconducting precursor wire constituting the compound superconducting precursor strand according to the embodiment. Among one or a plurality of transverse cross sections of the compound superconducting precursor wire 1 constituting the compound superconducting precursor strand, the maximum oblateness of the compound superconducting precursor portion 10 is preferably more than 0 and 0.2 or less. In other words, among the transverse cross section(s) of one or a plurality of compound superconducting precursor wire(s) 1 constituting the compound superconducting precursor strand, the oblateness of the most deformed compound superconducting precursor portion 10 is preferably more than 0 and 0.2 or less. When there is one compound superconducting precursor wire 1 constituting the compound superconducting precursor strand, the oblateness of the compound superconducting precursor portion 10 constituting the one compound superconducting precursor wire 1 is preferably more than 0 and 0.2 or less. When the oblateness of the compound superconducting precursor portion 10 is 0, the transverse cross-sectional shape of the compound superconducting precursor portion 10 is a perfect circle.

The oblateness of the compound superconducting precursor portion 10 is defined by (1-(b/a)). "a" is a major axis length of the compound superconducting precursor portion 10 in a transverse cross section (a cross section perpendicular to the wire axis direction) of the compound superconducting precursor wire 1. "b" is the minor axis length of the compound superconducting precursor portion 10 in the transverse cross section of the compound superconducting precursor wire 1. The major axis length of the compound superconducting precursor portion 10 corresponds to the maximum external dimension of the compound superconducting precursor portion 10, and the minor axis length of the compound superconducting precursor portion 10 corresponds to the minimum external dimension of the compound superconducting precursor portion 10.

If the oblateness of the compound superconducting precursor portion 10 is within the above range, the compound superconducting strand obtained by subjecting the compound superconducting precursor strand to compound superconductivity generating heat treatment can maintain a high critical current. For such a reason, with a smaller oblateness of the compound superconducting precursor portion 10, the superconducting property of the compound superconducting strand will be better.

Next, the compound superconducting strand according to the embodiment will be described. The compound superconducting strand according to the embodiment is obtained by heating the compound superconducting precursor strand of the above embodiment. This heat treatment is a compound superconductivity generating heat treatment for generating a compound superconducting phase.

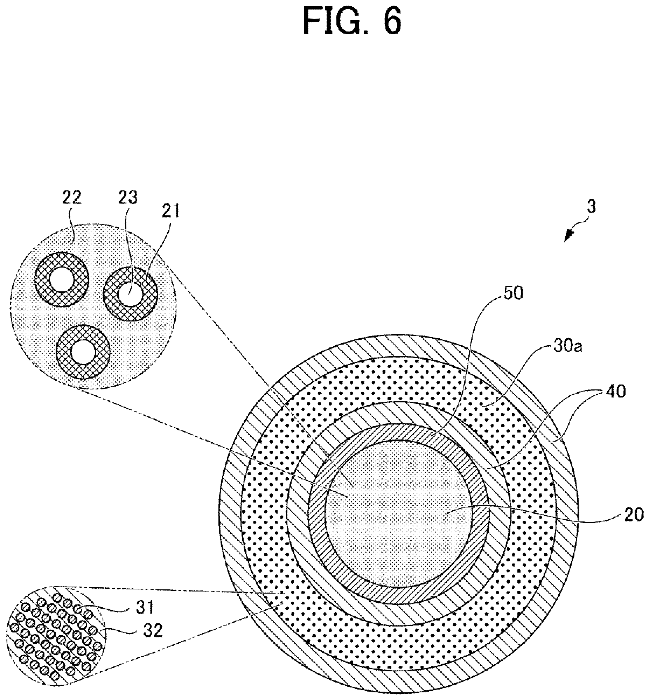

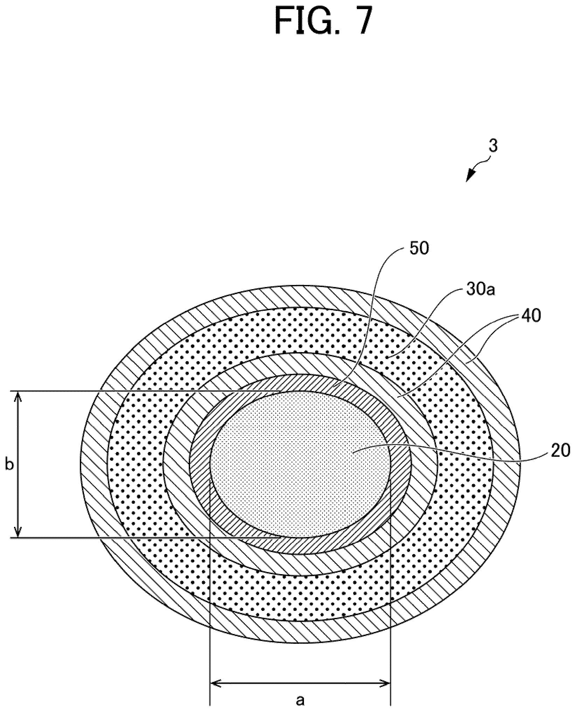

FIG. 5 is a transverse cross-sectional view showing an example of a compound superconducting wire constituting the compound superconducting strand according to the embodiment, and is a transverse cross-sectional view of a compound superconducting wire obtained by heating a compound superconducting precursor wire having the configuration of FIG. 1. FIG. 6 is a transverse cross-sectional view of a compound superconducting wire obtained by heating the compound superconducting precursor wire having the configuration of FIG. 2. FIG. 7 is a transverse cross-sectional view of a compound superconducting wire obtained by heating the compound superconducting precursor wire in the state of FIG. 4.

As shown in FIGS. 5 to 7, the compound superconducting wire 3 includes a compound superconductor portion 20, the reinforcing material portions 30 and 30a, and the stabilizing material portion 40. The compound superconducting wire 3 can be obtained by subjecting the compound superconducting precursor strand 2 including the plurality of compound superconducting precursor wires 1 to the compound superconducting generating heat treatment. The compound superconducting generating heat treatment may be conducted on the compound superconducting precursor strand 2 before coil winding, or may be conducted on the compound superconducting precursor strand 2 after coil winding.

The compound superconducting portion 20 constituting the compound superconducting wire 3 is configured by a plurality of compound superconducting filaments 21 including a compound superconducting phase, and a first matrix 22. The compound superconductor portion 20 is a linear shape, and extends along the axial direction of the compound superconducting wire 3. The first matrix 22 embeds the plurality of compound superconducting filaments 21 therein, and includes the first stabilizing material.

The compound superconducting phase is preferably a metal compound superconducting phase formed of Nb₃Sn. The compound superconducting phase is not limited to Nb₃Sn, and may be formed of, for example, Nb₃Al or another metal compound superconducting phase having a superconducting property.

The first matrix 22 including the first stabilizing material can exert effects of suppressing damage to the compound superconducting filament 21, magnetic stabilization, and thermal stabilization of the compound superconducting wire 3. When the first stabilizing material constituting the first matrix 22 is copper or a copper alloy, these effects are further improved.

Since the compound superconducting phase is preferably a metal compound superconducting phase formed of Nb₃Sn, in the case of a bronzing method Nb₃Sn precursor wire, the first stabilizing material is preferably formed of a Cu-Sn alloy. In addition, the material constituting the first stabilizing material is appropriately selected according to the type of the compound superconducting phase.

When the first stabilizing material of the first matrix 22 is a Cu-Sn alloy, the Sn content ratio in the first matrix 22 is smaller than the Sn content ratio in the first matrix precursor 12 constituting the compound superconducting precursor wire 1. As a result of using the Sn in the Cu-Sn alloy to produce Nb₃Sn filaments as the compound superconducting filaments 21, even if the Sn content ratio in the first matrix 22 is reduced to on the order of 0.1% by mass or more and 2.0% by mass or less, the first matrix 22 will not have a function as a stabilizing material corresponding to Cu.

FIGS. 5 and 6 show the compound superconductor portion 20 produced by the bronzing method. In the bronzing method, by subjecting the compound superconducting precursor wire 1 in a state in which a plurality of Nb filaments, which are the compound superconducting precursor filaments 11, are embedded in the first matrix precursor 12 of a Cu-Sn alloy that is the first stabilizing material, to the compound superconductivity generating heat treatment for generating a compound superconducting phase, Sn in the first matrix precursor 12 diffuses and then reacts with the surface of the Nb filaments, whereby Nb₃Sn filaments, which are the compound superconducting filaments 21, can be produced from the Nb filaments.

In addition, the enlarged views of the compound superconductor portion 20 shown in FIGS. 5 to 6 show examples in which a core portion 23 of unreacted Nb remaining is present without reacting with Sn. However, depending on the amount of Sn contained in the first matrix precursor 12 of the compound superconducting precursor wire 1, the diameter size of the compound superconducting precursor filament 11 of the compound superconducting precursor wire 1, and the like, the unreacted core portion 23 may not be present in the compound superconducting filament 21 of the compound superconducting portion 20, and the compound superconducting filament 21 may consists of Nb₃Sn.

The reinforcing material portion 30 is disposed in a cylindrical shape or to be distributed concentrically along the circumferential direction, and is disposed on the outer peripheral side of the compound superconductor portion 20. The reinforcing material portion 30 constituting the compound superconducting wire 3 has basically the same configuration and function as the reinforcing material portion 30 constituting the compound superconducting precursor wire 1.

The stabilizing material portion 40 has a cylindrical shape, and is disposed on at least one of the inner peripheral side and the outer peripheral side of the reinforcing material portion 30. FIGS. 5 to 7 show examples in which the stabilizing material portion 40 is disposed on both the inner peripheral side and the outer peripheral side of the reinforcing material portion 30. The stabilizing material portion 40 constituting the compound superconducting wire 3 has basically the same configuration and function as the stabilizing material portion 40 constituting the compound superconducting precursor wire 1.

As described above, since the 0.2% tensile strength of the compound superconducting precursor wire 1 is within a predetermined range, the yield strength against tension can be appropriately maintained by the reinforcing material portions 30 and 30a in the compound superconducting precursor wire 1, whereby the breakage of the compound superconducting precursor wire is suppressed, which has occurred conventionally in the stranding process for shortening the twisting pitch or in the molding process (compression process) for reducing the void ratio of the strand. Furthermore, since the Vickers hardness of the stabilizing material portion 40 is within the predetermined range, and the reinforcing material portions 30 and 30a protect the compound superconducting precursor portion 10, the stabilizing material portion 40 is selectively deformed in the molding process for reducing the void ratio of the strand, and thus abnormal deformation of the compound superconducting precursor portion 10 is suppressed. As a result, it is possible to obtain the compound superconducting precursor strand 2 having improved strand manufacturability and little deformation of the compound superconducting precursor portion 10.

In addition, in both the case of a compound superconducting magnet produced by a method (wind-and-react method) of subjecting the compound superconducting precursor strand 2 to the compound superconductivity generating heat treatment after coil winding, and the case of a compound superconducting magnet produced by a method (react-and-wind method) of subjecting the compound superconducting precursor strand 2 to the compound superconductivity generating heat treatment, and then subjecting to the coil winding, since not only the strain applied to the compound superconducting filament 21 of the compound superconducting wire 3 generated by the electromagnetic force applied to the compound superconducting wire 3 in the strand at the time of magnet excitation is reduced by compositing the reinforcing material portions 30 and 30a, but also deformation of the compound superconductor portion 20 is less, and thus the superconducting property is improved.

By configuring in this way, since both the strand manufacturability and the superconducting property are improved, rational magnet design becomes possible as a result. Specifically, in the compound superconducting magnet manufactured by the wind-and-react method, when electromagnetic stress generated at the time of excitation is repeatedly applied to the compound superconducting strand, processing strain is applied to the reinforcing material portion to increase the strength, and the superconducting property improves from the effect of the residual strain of the compound superconducting filament being mitigated. In addition, in the compound superconducting magnet manufactured by the react-and-wind method, excellent superconducting property can be obtained by subjecting the compound superconducting strand to an appropriate pre-bending strain application treatment at room temperature. As a result, with either manufacturing method, rational compound superconducting magnet design becomes possible.

According to the embodiment described above, by the characteristics of the stabilizing material portion constituting the compound superconducting wire and the characteristics of the compound superconducting precursor wire respectively satisfying a predetermined relationship, the strand manufacturability and the superconducting property are superior to those in the related art, and rational magnet design becomes possible.

Although embodiments have been described above, the present invention is not limited to the above embodiments, and various modifications can be made within the scope of the present disclosure, including all embodiments included in the gist and the claims of the present disclosure.

### EXAMPLES

Next, Examples and Comparative Examples will be described; however, the present disclosure is not limited to these Examples.

### (Example 1)

A compound superconducting strand was manufactured having a plurality of compound superconducting wires in which the compound superconductor portion is Nb₃Sn formed by the bronzing method, the compound superconducting wire was provided with a Sn diffusion prevention portion made of Ta, the reinforcing material portion was a Cu-Nb composite material in which Nb filaments were embedded in a matrix of oxygen-free copper, and the compound superconducting wire had a stabilizing material portion made of oxygen-free copper on the outer peripheral side of the reinforcing material portion. This will be described in detail below.

A composite wire of the Nb rods and the CuSn alloy was obtained by conducting extrusion and wire drawing on a billet in which a plurality of Nb rods were embedded in a CuSn alloy to which Ti was added. Subsequently, a plurality of these composite wires were arranged at a central portion of an oxygen-free copper tube to form an assembly, tubular Ta as a Sn diffusion prevention portion was arranged on an outer periphery of this assembly, an oxygen-free copper tube was arranged on the outer periphery of the tubular Ta, and a plurality of wires for a Cu-Nb reinforcing material portion obtained by conducting extrusion processing and wire drawing processing on a billet in which a plurality of Nb rods were embedded in oxygen-free copper were arranged on the outer periphery of the oxygen-free copper tube, thereby obtaining a billet for the compound superconducting precursor wire. Subsequently, the billet for the compound superconducting precursor wire was subjected to extrusion wire drawing to obtain a wire. Next, the wire was subjected to heat treatment at 200°C or more and 500°C or less for several seconds or more and several hours or less to refine the wire, thereby obtaining a compound superconducting precursor wire.

Subsequently, as shown in FIG. 3, the two compound superconducting precursor wires having a diameter of 0.83 mm and one copper wire having a diameter of 0.83 mm were twisted together to make a primary stranded wire, the three primary stranded wires were twisted together to make a secondary stranded wire, the four secondary stranded wires were twisted together to make a tertiary stranded wire, and the tertiary strand wire was subjected to rectangular molding to obtain a compound superconducting precursor strand. The twisting pitches of the primary twist, the secondary twist, and the tertiary twist were 25 mm, 48 mm, and 90 mm, respectively. The rectangular molding process of the tertiary stranded wire established a 30% void ratio of the strand. Herein, the void ratio of the strand is the proportion of an area obtained by excluding a total area of all the compound superconducting precursor wires and all the copper wires to an area within the dotted line of the rectangular shape shown in FIG. 3.

Subsequently, the compound superconducting precursor strand was subjected to a compound superconducting generating heat treatment at 570°C or more and 670°C or less for several 100 hours to obtain the compound superconducting strand shown in Table 1.

### (Example 2)

A compound superconducting strand was produced in the same manner as in Example 1, except for changing the reinforcing material portion to Ta, providing the stabilizing material portion to the inner peripheral side and the outer peripheral side of the reinforcing material portion, and changing the space factors of the reinforcing material portion and the stabilizing material portion and changing the 0.2% tensile strength of the compound superconducting precursor wire to the values shown in Table 1.

### (Comparative Example 1)

A compound superconducting strand was produced in the same manner as in Example 1 except for not performing refinement.

### (Comparative Example 2)

A compound superconducting strand was produced in the same manner as in Example 2 except for not performing refinement.

### (Comparative Example 3)

A compound superconducting strand was produced in the same manner as in Example 1 except for not providing the reinforcing material portion, and changing the space factor of the stabilizing material portion to the value shown in Table 1.

### (Comparative Example 4)

A compound superconducting strand was produced in the same manner as in Example 3 except for not performing refinement.

The following characteristics were examined for the compound superconducting precursor wires taken out from the compound superconducting precursor strands, and the compound superconducting wires taken out from the compound superconducting strands produced in the above Examples and Comparative Examples. The results are shown in Table 1.

The Vickers hardness of the stabilizing material portion was measured as follows. First, a sample in which the compound superconducting precursor wire was embedded in an epoxy resin was cut perpendicularly to the axial direction of the compound superconducting precursor wire, and the cut section was polished. Subsequently, according to JIS Z 2244, a pyramid indenter made of diamond was pressed against the transverse cross section of the compound superconducting precursor wire at a load of 10 g for 15 seconds, and the Vickers hardness of the stabilizing material portion was measured by a micro Vickers hardness test for measuring the generated indentation.

The 0.2% tensile strength of the compound superconducting precursor wire employed a method according to 5. (tension) in JIS C 3002. Specifically, 40 mm at both ends of the compound superconducting precursor wire having a length of 180 mm were chucked, and a straight line equivalent to the Young's modulus obtained when applying a tensile strain of 0.2% to 0.5% in the axial direction, and then unloading, was offset to a strain of 0.2%, and the intersection point (stress degree) with the stress strain curve was set as 0.2% tensile strength.

The critical current of the compound superconducting wire was measured as follows. In a state where an external magnetic field of 14.5 T was applied to the compound superconducting wire having a length of 5 cm perpendicularly to the axial direction of the wire in liquid helium (4.2 K), and the current value when energizing the compound superconducting wire and an electric field of 0.1 µV/cm was generated in the compound superconducting wire by the four-terminal method (with a voltage tap distance of 1 cm) was defined as the critical current value.

**[Table 1]**

| Item | | | Units | Example 1 | Example 2 | Comparative Example 1 | Comparative Example 2 | Comparative Example 3 | Comparative Example 4 |
|---|---|---|---|---|---|---|---|---|---|
| | | Diameter | mm | 0.83 | 0.83 | 0.83 | 0.83 | 0.83 | 0.83 |
| | | Reinforcing material portion | % | Cu-Nb | Ta | Cu-Nb | Ta | No | No |
| | | Refinement | - | Yes | Yes | No | No | Yes | No |
| | | Vickers hardness (HV) of stabilizing material portion | - | 70 | 70 | 110 | 110 | 70 | 110 |
| | | 0.2% tensile strength of compound superconducting precursor wire | MPa | 270 | 220 | 380 | 370 | 180 | 360 |
| Structure of compound superconducting precursor wire | | Space factor of compound superconducting portion including Sn diffusion prevention portion | % | 50% | 50% | 50% | 50% | 50% | 50% |
| | | Space factor of stabilizing material portion on inner peripheral side of reinforcing material portion | % | 0% | 15% | 0% | 15% | 0% | 0% |
| | | Space factor of reinforcing material portion | % | 25% | 10% | 25% | 10% | 0% | 0% |
| | | Space factor of stabilizing material portion on outer peripheral side of reinforcing material portion | % | 25% | 25% | 25% | 25% | 50% | 50% |
| Evaluation | Strand manufacturability | Breakage occurrence frequency (number of wire breaks per 1 km of compound superconducting precursor wire in primary-twist to compound superconducting precursor strand) | - | 0 | 0 | 0 | 0 | 1 | 2 |
| | | Oblateness of compound superconducting precursor portion of wire having largest deformation, in compound superconducting precursor strand cross section (when 30% void ratio) | - | 0.09 | 0.17 | 0.26 | 0.23 | 0.24 | 0.31 |
| | Superconducting property (critical current) | Critical current of untwisted compound superconducting wire (4.2K,14.5T) | A | 143 | 145 | 136 | 141 | 140 | 133 |
| | | Critical current of compound superconducting wire when applying tensile stress of 200 Mpa (4.2K, 14.5T) | A | 170 | 155 | 162 | 150 | 130 | 124 |

As shown in Table 1, when using the compound superconducting precursor wire in which the Vickers hardness of the stabilizing material portion was 90 or less and the 0.2% tensile strength of the compound superconducting precursor wire was 200 MPa or more, the strand manufacturability and the superconducting property were excellent.

In addition, when making a comparison between Example 1 and Comparative Example 1, and a comparison between Example 2 and Comparative Example 2, the oblateness of the compound superconducting precursor portion of the compound superconducting precursor wire having the largest deformation in a transverse cross section of the compound superconducting precursor strand was 0.2 or less, by conducting the refinement which controls the Vickers hardness of the stabilizing material portion and the 0.2% tensile strength of the compound superconducting precursor wire, and as a result, the critical current of the untwisted compound superconducting wire was maintained at a relatively high value.

Furthermore, in Examples 1 and 2 as compared with Comparative Examples 3 and 4, the abnormal deformation occurrence frequency of the compound superconducting precursor portion was low, and the oblateness of the most deformed compound superconducting precursor portion was low; therefore, the strand manufacturability was improved from the effects of the present disclosure. Then, the critical current (4.2 K, 14.5 T) when applying the tensile stress of 200 MPa was a value nearly 30% higher than that in the case where the reinforcing material portion was not provided, due to the effect of being composited with the reinforcing material portion.

It should be noted that, although the Nb in the Cu-Nb composite material is effective in dispersing in the form of filaments in the Cu matrix as in the above-described Examples, the same effect can be obtained even when laminating Cu and Nb in the form of sheets. In addition, in the above-described Examples, although surface treatment of the compound superconducting precursor wire or the copper wire is not conducted, when the wire surface is subjected to treatment such as Cr plating, oxygen-free copper parts in contact with each other on the wire surface in the strand are not fused to each other during the compound superconductivity generating heat treatment of the compound superconducting precursor strand, and it is possible to suppress the generation of added alternating current loss due to the flexibility of the compound superconducting strand itself and the coupling current flowing between the wires when the variable magnetic field is applied in the operation of the superconducting magnet. Furthermore, in the above-described Examples, the effects of the present invention were confirmed for specific numerical values at which strand manufacture is difficult with respect to the wire diameter, the number of twists of each order of stranded wire, the twisting pitch, the twisting degree (the number of times of twisting multiple times), and the void ratio after molding process; however, the effects of the present invention are not limited to these numerical values, and are effective for the wire diameter, the number of twists of each order of stranded wire, the twisting pitch, the twisting degree, and the void ratio, which are arbitrarily designed to satisfy the required characteristics such as the current-carrying capacity of the compound superconducting strand.

1 compound superconducting precursor wire
2 compound superconducting precursor strand
2a primary stranded wire
2b secondary stranded wire
2c tertiary stranded wire
3 compound superconducting wire
10 compound superconducting precursor portion
11 compound superconducting precursor filament
12 first matrix precursor
20 compound superconducting portion
21 compound superconducting filament
22 first matrix
23 core portion
30, 30a reinforcing material portion
31 reinforcing filament
32 third matrix
40 stabilizing material portion
50 Sn diffusion prevention portion
60 copper wire

## Claims

1. A compound superconducting precursor wire comprising:
a compound superconducting precursor portion comprising a plurality of compound superconducting precursor filaments, and a first matrix precursor having the plurality of compound superconducting precursor filaments embedded therein and including a first stabilizing material;
a reinforcing material portion disposed on an outer peripheral side of the compound superconducting precursor portion; and
a stabilizing material portion which is disposed on at least one of an inner peripheral side and an outer peripheral side of the reinforcing material portion, and consisting of a second stabilizing material,
wherein a Vickers hardness (HV) of the stabilizing material portion is 90 or less, and a 0.2% tensile strength of the compound superconducting precursor wire is 200 MPa or more.

2. The compound superconducting precursor wire according to claim 1, wherein the reinforcing material portion consists of one metal selected from the group consisting of Nb, Ta, V, W, Mo, Fe, Ti and Hf, or an alloy or composite material composed of two or more of the metals.

3. The compound superconducting precursor wire according to claim 1, wherein the reinforcing material portion is configured by a plurality of reinforcing filaments, and a third matrix having the plurality of reinforcing filaments embedded therein and including a third stabilizing material.

4. The compound superconducting precursor wire according to claim 3, wherein the reinforcing filament consists of one metal selected from the group consisting of Nb, Ta, V, W, Mo, Fe, Ti, and Hf, or an alloy composed of two or more of the metals, and the third stabilizing material is copper or a copper alloy.

5. The compound superconducting precursor wire according to any one of claims 1 to 4, wherein the compound superconducting precursor filament is an Nb₃Sn precursor, and the compound superconducting precursor wire further comprises a Sn diffusion prevention portion consisting of Nb or Ta, or an alloy or composite material thereof, between the compound superconducting precursor portion and the reinforcing material portion.

6. The compound superconducting precursor wire according to any one of claims 1 to 5, wherein the first stabilizing material is copper or a copper alloy.

7. The compound superconducting precursor wire according to any one of claims 1 to 6, wherein the second stabilizing material is copper or a copper alloy.

8. The compound superconducting precursor wire according to any one of claims 1 to 7, wherein
a space factor of the reinforcing material portion is 5.0% or more and 40.0% or less, and smaller than a space factor of the compound superconducting precursor portion, and
a space factor of the stabilizing material portion disposed on an outer peripheral side of the reinforcing material portion is 15.0% or more.

9. A compound superconducting precursor strand comprising, as a constituent element, a secondary stranded wire provided by twisting together a plurality of primary stranded wires provided by twisting together a plurality of the compound superconducting precursor wires according to any one of claims 1 to 8.

10. A compound superconducting precursor strand comprising, as a constituent element, a secondary stranded wire provided by twisting together a plurality of primary stranded wires provided by twisting together one or a plurality of the compound superconducting precursor wires according to any one of claims 1 to 8, and one or a plurality of copper wires or copper alloy wires.

11. The compound superconducting precursor strand according to claim 10, wherein a Vickers hardness (HV) of the copper wire or the copper alloy wire is 90 or less.

12. The compound superconducting precursor strand according to any one of claims 9 to 11, wherein a maximum oblateness of the compound superconducting precursor portion in one or a plurality of transverse cross sections of the compound superconducting precursor wires constituting the compound superconducting precursor strand is more than 0 and 0.2 or less.

13. A compound superconducting strand obtained by heating the compound superconducting precursor strand according to any one of claims 9 to 12.
